# EUROPEAN PATENT APPLICATION

(11) **EP 4 477 983 A1**
(43) Date of publication of application: **18.12.2024**
(21) Application number: 23382590.0
(22) Date of filing: 14.06.2023
(51) Int. Cl.: F28F 3/12

(54) **HEAT EXCHANGER FOR COOLING ONE OR MORE ELECTRICAL OR ELECTRONIC DEVICES**

(71) Applicant: BORGWARNER EMISSIONS SYSTEMS SPAIN, S.L.U., 36315 Vigo Pontevedra (ES)
(72) Inventor: HERMIDA, Xoán, 36380 Gondomar (ES); LOZANO, Francisco, 36400 O Porriño (ES); LAGO, David, 36201 Vigo (ES)
(74) Representative: ABG Intellectual Property Law, S.L.

(57) **Abstract**

The present invention relates to a heat exchanger device for cooling one or more electrical or electronic devices, wherein the electrical or electronic device generates heat that must be drained through an outer exchange surface. Improvement in heat transfer requires close contact between the surface of the device to be cooled and of the heat exchanger responsible for removing heat, and this close contact requires the application of large mechanical stresses. The exchanger is configured such that it improves robust response without reducing the exchange capacity with the electrical or electronic device. The present invention presents the advantages of energy efficiency and therefore has a relevant impact on the environment.

## Description

### OBJECT OF THE INVENTION

The present invention relates to a heat exchanger device for cooling one or more electrical or electronic devices, wherein the electrical or electronic device generates heat that must be drained through an outer exchange surface.

Improvement in heat transfer requires close contact between the surface of the device to be cooled and of the heat exchanger responsible for removing heat, and this close contact requires the application of large mechanical stresses. The exchanger is configured such that it improves robust response without reducing the exchange capacity with the electrical or electronic device.

Several embodiments combine specific materials which allow maintaining a high capacity to withstand mechanical stresses and a good heat transfer between the liquid coolant and the electrical or electronic device to be cooled.

The present invention presents the advantages of energy efficiency and therefore has a relevant impact on the environment.

### BACKGROUND OF THE INVENTION

Developments in technological fields such as the field of electric vehicles impose increasingly demanding design requirements on electrical components and particularly on electronic devices such as switching devices in which heat dissipation is high and it is essential to keep the temperature of the semiconductor below a maximum temperature that prevents its degradation or even destruction.

Examples of devices with high cooling requirements are MOSFET (metal-oxide-semiconductor field-effect transistors) or IGBT (insulated gate bipolar transistor) transistors present in apparatus such as inverters or PWM (pulse with modulation) modulators.

In this field of technology, dissipation occurs through solid surfaces with very small exchange areas, with very high dissipation powers per unit area and with increasing power requirements per unit area.

Conduction is the dominant dissipation mechanism for causing heat discharge from the device to be cooled. To increase heat transfer between two contacting surfaces, it is common to interpose substances that ensure close contact between the substance and the surface to be cooled, as well as between the substance and the surface of the heat exchanger. This substance must have good thermal conductivity properties, although the smaller the thickness, the lower the thermal resistance it presents in heat conduction from the device to be cooled and the heat exchanger.

One of the ways for ensuring close contact between the two surfaces is to apply a force between the device and the heat exchanger, usually by means of screws, bolts, or clamps that apply localized forces, for example on the periphery of the heat exchanger or on the surface of the heat exchanger, tending to bring the two devices closer together.

While the natural tendency would suggest using deformable materials to achieve the adaptation of one surface to another, the inventors have observed that, when the heat exchanger has an essentially flat configuration and deformable materials are used, the localized force at two or more points of the heat exchanger causes deformations that reduce the pressure needed in the regions where good close contact is required on the surface where heat exchange with the electrical or electronic device takes place.

For example, bending deformation causes the inability of the deformed configuration to adapt well to the shape of the heat dissipating device, having a very high negative impact on thermal conduction either because there are separations between surfaces in certain regions or because they are separated by increasing the thickness of the interposed contact substances. The bending stresses that can generate excessive deformations can occur mainly in the longitudinal direction but also in the transverse direction.

Additionally, not all materials, regardless of their deformation capacity, are good thermal conductors.

A common solution is to use materials with good thermal conductivity and sufficient thickness to provide sufficient structural stiffness. In contrast, although the material used is a good thermal conductor, increasing the thickness of an exchange wall increases the distance that heat must be conducted through the material and therefore proportionally increases thermal resistance in detriment of the desired effect.

The present invention solves these problems by using a specific heat exchanger structure and combining materials, such that the improved structural behavior does not impair good heat transfer from the device to be cooled to the heat exchanger.

### DESCRIPTION OF THE INVENTION

The invention relates to a heat exchanger for cooling one or more electrical or electronic devices. The exchanger comprises:
- *a base comprising*
   *an inlet port for the entry of a coolant,*
   *an outlet port for the exit of the coolant,*
   *a wall extending along a longitudinal direction, the direction which connects the inlet port and the outlet port of the base,*
- *a cover attached on the base and configured to establish a chamber for the passage of the coolant between the inlet port and the outlet port of the base and wherein the cover comprises a wall extending along the longitudinal direction;*
*wherein the wall of the base or the wall of the cover or both comprise at least one heat exchange region adapted to transfer heat from an outer area to an inner area of the chamber and opposite the outer area.*

The electrical or electronic device has a surface adapted to transfer heat through conduction by contact with a surface of the heat exchanger that drains the heat. According to the invention, the heat transfer is between this surface of the device to be cooled and the outer surface in contact with the device, this outer surface being a surface of the wall of the base of the device, a surface of the wall of the cover, or even a surface in the walls of both parts of the exchanger according to the invention. It is at the contact between both surfaces, i.e., the surface of the electrical or electronic device and the surface of the exchange region of the heat exchanger, where there can be arranged, normally, according to preferred embodiments of the invention, a substance which improves the close contact between the two facing surfaces.

When the heat exchange region is in the cover, it is considered that the cover is formed by a wall which, according to preferred examples, is formed by a sheet metal configured by stamping.

The wall through which heat exchange occurs in the operating mode establishes a physical separation between the outer surface adapted to cool the electrical or electronic device to be cooled and the inside of the heat exchanger through which a liquid coolant circulates. The heat is transferred by conduction through the wall and according to the conduction properties of the material of the wall.

In preferred examples, the thickness of the wall of the base is greater than the thickness of the wall of the cover, such that the base provides the exchanger with a higher resistance capacity, in particular to bending.

In preferred examples, the thickness of the wall of the base and/or of the cover is at least 0.5 mm, at least 1.0 mm, at least 1.5 mm, at least 2.0 mm, at least 2.5 mm, at least 3.0 mm; more preferably, the thickness of the wall of the base or of the cover is of at least 0.5 mm and less than 5.0 mm, even more preferably between 0.5 mm and 3.0 mm. Preferably, the thickness of the wall of the base is greater than the thickness of the wall of the cover. In examples applying the preceding examples, the thickness of the wall of the cover represents between 10% and 90%; particularly between 20% and 60%; of the thickness of the wall of the base.

The wall of the cover and the wall of the base, according to preferred examples, are parallel and spaced apart from one another. Given that both walls are structurally connected, the spacing increases the moment of inertia and therefore the structural stiffness of the heat exchanger.

The liquid coolant circulates through a chamber formed between the wall of the base and the cover, allowing the liquid coolant to circulate in the operating mode by removing heat from the inner surface of the exchange region through convection.

For this circulation to occur, the exchanger comprises at least one inlet port and an outlet port between which there is established the circulation of the liquid coolant.

According to preferred embodiments, the wall of the base or the wall of the cover or both is attached to one or more dissipating fins to favor greater heat exchange between the wall and the liquid coolant. According to other embodiments, these fins are distributed in groups preferably in regions of the inner surface of the wall which correspond to regions in which the devices to be cooled are arranged on the opposite surface. In some embodiments, one or more dissipating fins are attached to the wall of the base; in other embodiments, one or more dissipating fins are attached to the wall of the cover. According to other embodiments, the dissipating fins are attached both to the cover and to the base.

In preferred embodiments, said fins comprise
∘ a metallic material comprising copper as the ingredient in the highest amount by weight; or
∘ a metallic material comprising aluminum as the ingredient in the highest amount by weight.

In one embodiment, the fins comprise, and particularly consist of, a metallic material comprising copper as the ingredient in the highest amount by weight, preferably the metallic material is copper. In an alternative embodiment, the fins comprise, and particularly consist of, a metallic material comprising aluminum as the ingredient in the highest amount by weight, preferably the metallic material is aluminum. In more particular embodiments, these materials are as defined below in the sections *"Metallic material comprising copper as the ingredient in the highest amount by weight"* and *"Metallic material comprising aluminum as the ingredient in the highest amount by weight".*

According to other embodiments, the cover is also a surface that can be configured to drain heat from devices which are in contact with the outer surface of said cover.

Therefore, both the outer surface of the wall of the base and the outer surface of the cover are suitable for heat exchange with an electrical or electronic device that is in contact therewith.

Heat exchange region shall be interpreted as those parts of a wall which are adapted to transfer heat, that is, parts of the wall in which heat is transferred by conduction from the outer surface adapted to be in contact with the electrical or electronic device and the inner surface oriented towards the inside of the chamber, where it is either in contact with the liquid coolant or, according to embodiments with a dissipating fin intended for increasing heat draining.

The surface being adapted to be in contact with the electronic device should be interpreted as follows:
- the surface receives in the operating mode contact or attachment with an electrical or electronic device in order to remove heat from same, giving rise to a surface area delimiting the exchange region that is equal to the contact area, or
- allows contact and attachment with the electrical or electronic device although in a specific condition of use the contact area is smaller than the adapted surface area although said larger adapted area would be usable in other operating conditions.

To mention a few examples that can be combined with one another, the examples of configuring a heat exchange region are as follows:
a) the material of the heat exchange region comprises a metallic heat transfer material as defined below,
b) the outer surface is complementary to the surface of the electrical or electronic device to be cooled, or
c) the thickness of the wall of the exchange region is reduced with respect to the rest of the wall in order to reduce thermal resistance.

In a preferred embodiment, configurations a) and c) are combined.

It is considered that condition b), i.e., the outer surface of the exchange region is complementary to the surface of the electrical or electronic device to be cooled, will be a minimum condition for all cases.

Additionally, according to embodiments, the heat exchange region can offer a larger area with respect of this minimum condition.

However, the problem generated by the use of materials which are good thermal conductors but have a lower mechanical resistance, and the structural weakness which may arise from the use of reduced thicknesses, is solved according to the invention given that the heat exchanger is further characterized in that:
- *the wall of the base or the wall of the cover or both comprise,* and particularly consist of, *a structural metallic material which is selected from:*
   ∘ *steel;*
      *and*
   ∘ *a metallic material comprising aluminum as the ingredient in the highest amount by weight; and,*
- *the wall of the base or the wall of the cover or both comprising, in particular consisting of, a structural metallic material extend at least one segment along the longitudinal direction, wherein at least one heat exchange region is arranged between the ends of said segment also according to the longitudinal direction; and,*
- *at least one heat exchange region comprises, and particularly consists of, a metallic heat transfer material.*

The inclusion of the heat exchange region (R) comprising, and particularly consisting of, the metallic heat transfer material in at least a part of the base or part of the cover extending longitudinally, gives rise to a device which, on one hand, maintains the walls that transfer heat by conduction between the surface in contact with the device to be cooled and the liquid coolant of a material which is a good thermal conductor, but that region (R) is not necessarily responsible for structural stiffness. This greater structural stiffness in the longitudinal direction, which is where the greatest bending deformations occur, is provided by the structural metallic material part extending according to this same longitudinal direction. *Vice versa,* it cannot be excluded that the structural metallic material of the wall of the base or the wall of the cover or both, as defined above, contributes to heat transfer between the surface in contact with the device to be cooled and the liquid coolant of a material which is a good thermal conductor, although the main function thereof is to provide structural stiffness.

According to embodiments, the heat exchange region (R) can be in the wall of the base, or in the wall of the cover, or in the wall of both, i.e., the base and cover.

Additionally, according to some of these preferred examples of the invention, the wall comprising a structural metallic material is the wall of the base when the heat exchange region (R) is also in the base.

Additionally, according to others of these preferred examples of the invention, the wall comprising a structural metallic material is the wall of the cover when the heat exchange region (R) is also in the cover.

Additionally, according to others of these preferred examples of the invention, the wall comprising a structural metallic material is the wall of the base when the heat exchange region (R) is in the cover and, *vice versa,* according to others of these preferred examples of the invention, the wall comprising a structural metallic material is the wall of the cover when the heat exchange region (R) is in the base.

In these embodiments, the condition that the wall comprising a structural metallic material extending at least one segment along the longitudinal direction such that at least one heat exchange region (R) is arranged between the ends of said segment also according to the longitudinal direction should be interpreted in terms of projection, that is, regardless of the position thereof according to any of the transverse directions. In other words, this condition can be determined even if the wall comprising a structural metallic material is in one part, for example in the base, and the exchange region is in the other part, for example in the cover. What is relevant will be the relative position and extension thereof according to the longitudinal direction.

### Materials used in the present invention

The present invention relates to the following metallic materials:
- Steels;
- Metallic material comprising copper as the ingredient in the highest amount by weight;
- Metallic material comprising aluminum as the ingredient in the highest amount by weight.

The term "metallic material" refers to a material comprising a metal in its composition. The metallic material is referred to as a "structural" material when the material has the following yield strength and Young modulus values:
- yield strength at room temperature (for example, at 20°C) is comprised between 100 and 1000 MPa, more preferably between 200 and 1000 MPa (according to UNE-EN ISO 6892-1:2020);
- Young modulus at room temperature (for example, at 20°C) is comprised between 68 and 220 GPa, more preferably between 170 and 220 GPa (according to UNE-EN ISO 6892-1:2020).

The metallic material is referred to as a "heat transfer" material when it has a thermal conductivity at 20°C of at least 8, preferably at least 20, even more preferably at least 150 W/mK, for example between any of these values and 300 W/mK, preferably and 400 W/mK (according to ASTM C177 standard or alternatively ISO 8302 standard).

### Metallic material: steel

In one embodiment, the metallic material is steel. The term steel refers to an alloy comprising iron and carbon, and optionally additional elements, wherein carbon is in amounts of 2.1% by weight or less with respect to the weight of the steel; and, preferably, wherein iron is the ingredient in the highest percentage by weight with respect to the weight of the steel.

In one embodiment, the steel has a thermal conductivity at 20°C of at least 8 W/mK. In a particular embodiment, the steel has a thermal conductivity at 20°C of between 8 and 70 W/mK. Thermal conductivity can be measured according to the standards indicated above.

In a preferred embodiment, the steel is a stainless steel. Stainless steel is a very strong metal alloy which allows a quality welded attachment by brazing. Therefore, stainless steel is particularly preferred as the structural metallic material. Furthermore, it is a metal which ensures a very high level of resistance without the liquid coolant or the environment in which the exchanger is located generating oxides that would reduce the service life thereof, particularly with high temperatures.

The term "stainless steel" refers to steel comprising at least 10.5% by weight of chromium with respect to the weight of the steel, usually between 10.5% and 30% by weight of chromium with respect to the weight of the steel; and at most 1.2% of carbon with respect to the weight of the steel. Stainless steels may further comprise one or more elements selected from silicon, manganese, phosphorus, sulfur, molybdenum, nickel, nitrogen, copper, titanium, niobium, tungsten, aluminum, cobalt, zirconium, selenium, cerium, boron, or vanadium; in addition to incidental impurities. The rest is iron until the sum of the ingredients reaches 100% by weight with respect to the weight of the steel. Preferably, iron is the ingredient in the highest percentage by weight with respect to the weight of the steel.

An incidental impurity refers to a substance that is not intentionally added and can be found comprised in a raw material, such as ore or scrap, which is used to add other elements that are indeed desired, or which can be unintentionally incorporated during the process of producing the desired alloy. Impurities can be present in an amount that does not negatively affect the yield of the present invention.

In one embodiment, the stainless steel comprises, and particularly consists of:
- carbon in an amount of 0.015 to 0.3%, preferably 0.02 to 0.2%;
- silicon in an amount of 0.2 to 4.5%, preferably 0.7 to 2.5%;
- manganese in an amount of 0.5 to 14.5%, preferably 1.0 to 2.0%;
- phosphorus in an amount of 0.02 to 0.07%, preferably 0.03 to 0.045%;
- sulfur in an amount of 0.005 to 0.35%, preferably 0.01 to 0.35%;
- chromium in an amount of 10.5 to 30.0%, preferably 16.0 to 26.0%;
- molybdenum in an amount of 0 to 8.0%, preferably 0 to 5.0%;
- nickel in an amount of 0 to 37.0%, preferably 0 to 26.0%;
- nitrogen in an amount of 0 to 0.6%, preferably 0 to 0.22%;
- copper in an amount of 0 to 4.0%, preferably 0 to 2.0%;
- titanium in an amount of 0 to 1.0%, preferably 0 to 0.8%;
- niobium in an amount of 0 to 1.5%, preferably 0 to 1.0%;
- tungsten in an amount of 0 to 2.5%, preferably 0% to a maximum as an incidental impurity;
- aluminum in an amount of 0 to 1.5%, preferably 0% to a maximum as an incidental impurity;
- cobalt in an amount of 0 to 2.0%, preferably 0% to a maximum as an incidental impurity;
- zirconium in an amount of 0 to (7x(C+N)+0.15)% (C and N refer to the amount by weight of carbon and nitrogen, respectively, with respect to the weight of the steel), preferably 0% to a maximum as an incidental impurity;
- cerium in an amount of 0 to 0.1%, preferably 0% to a maximum as an incidental impurity;
with respect to the weight of the steel;
- incidental impurities;
- the rest being iron until the sum of the ingredients reaches 100% by weight with respect to the weight of the steel. Preferably, iron is the ingredient in the highest percentage by weight with respect to the weight of the steel.

In one embodiment, the steel, as defined in any of the preceding embodiments, can be austenitic, ferritic, martensitic, or duplex. In a preferred embodiment, the steel is austenitic or ferritic. In a particular embodiment, the steel is austenitic. In another particular embodiment, the steel is ferritic. These terms have their common meaning in the field of metallurgy and are defined, for example, in the EN 10088-1:2014 (E) standard.

Specific non-limiting examples of stainless steels that can be used in the context of the present invention are 1.4310, 1.4319, 1.4301, 1.4307, 1.4404, 1.4305, 1.4539, 1.4841, 1.4845, 1.4828, 1.4016, 1.4004, 1.4019, 1.4509, 1.4521, 1.4462, 1.4480 steels according to the EN 10088-1:2014 (E) standard.

These steels are commercially accessible through various sellers, such as Acerinox S.A. or Volnox Internacional, S.L.

In one embodiment, the stainless steel as defined in any of the preceding embodiments has a thermal conductivity at 20°C of at least 8, preferably at least 12, even more preferably at least 15 W/mK. In a particular embodiment, the stainless steel has a thermal conductivity at 20°C of between 8, preferably 12, even more preferably 15 W/mK, and 30 W/mK. More particularly, the stainless steel has a thermal conductivity at 20°C of between 8. preferably 12, even more preferably 15 W/mK, and 25 W/mK.

In another preferred embodiment, the steel is a carbon steel. Generally, carbon steels have a thermal conductivity greater than that of the stainless steels, and therefore are particularly preferred as the metallic heat transfer material. The term "carbon steel" refers to steel comprising between 0.05% and 2.1% by weight of carbon with respect to the weight of the steel. Carbon steels may further comprise one or more elements selected from manganese, phosphorus, sulfur, silicon, boron, or chromium. Preferably, iron is the ingredient in the highest percentage by weight with respect to the weight of the steel.

In one embodiment, the carbon steel comprises, and particularly consists of:
- carbon in an amount of 0.08 to 0.55%;
- manganese in an amount of 0 to 1.60%;
- phosphorus in an amount of 0.020 to 0.045%;
- sulfur in an amount of 0.020 to 0.045%;
- silicon in an amount of 0 to 0.55%;
- boron in an amount of 0 to 0.003%;
- incidental impurities;
- the rest being iron until the sum of the ingredients reaches 100% by weight with respect to the weight of the steel. Preferably, iron is the ingredient in the highest percentage by weight with respect to the weight of the steel.

In one embodiment, the carbon steel, as defined in any of the preceding embodiments, can be austenitic, ferritic, martensitic, or duplex. In a preferred embodiment, the steel is austenitic or ferritic. In a preferred embodiment, the steel is ferritic.

Specific non-limiting examples of carbon steels that can be used in the context of the present invention are the following steels: 1.0330, 1.0347, 1.0338 according to the EN 10130:2007-02 standard; 1.0332, 1.0398. 1.0335, 1.0389 according to the EN10111:2008 standard; 1.0033, 1.0034, 1.0308, 1.0225, 1.0580 according to the EN 10305-2:2016 standard.

These steels are commercially accessible through various sellers, such as Vizcaína de Industria y Comercio S.L., pauly STAHLHANDEL, or ArcelorMittal.

In one embodiment, the carbon steel as defined in any of the preceding embodiments has a thermal conductivity at 20°C of at least 20 W/mK. In a particular embodiment, the carbon steel has a thermal conductivity at 20°C of between 20 W/mK and 60 W/mK. More particularly, the carbon steel has a thermal conductivity at 20°C of between 20, preferably 25 W/mK, and 40 W/mK, preferably 35 W/mK. More particularly, the carbon steel has a thermal conductivity of about 30 W/mK.

The steels described above can be formed such that they acquire the desired shape for use thereof in the heat exchanger. The steel can be formed by means of techniques well known by one skilled in the art such as lamination, forging, stamping, upset forging, extrusion, or hydroforming.

### Metallic material comprising copper as the ingredient in the highest amount by weight

In a particular embodiment, the metallic material is a metallic material, preferably a metallic alloy, comprising copper as the ingredient in the highest amount by weight.

In a preferred embodiment, the metallic material comprises copper preferably in an amount of at least 60%, more preferably of at least 85%, even more preferably of at least 95%, still more preferably of at least 99%, by weight with respect to the weight of the metallic material. In one embodiment, the metallic material consists essentially of copper, more particularly it is copper.

In one embodiment, the rest of the percentage by weight, to reach 100% by weight with respect to the weight of the metallic material, comprises, or more particularly consists of:
- one or more elements selected from bismuth, oxygen, silver, cadmium, chromium, antimony, selenium, tellurium, zinc, silicon, aluminum, arsenic, beryllium, carbon, cobalt, iron, manganese, nickel, phosphorus, lead, sulfur, tin;
- incidental impurities.

In one embodiment, the metallic material comprises, and particularly consists of:
- bismuth in an amount of 0% to 0.0005%;
- oxygen in an amount of 0% to 0.1%;
- silver in an amount of 0% to 0.015%;
- cadmium in an amount of 0% to 0.05%;
- chromium in an amount of 0% to 0.05%;
- antimony in an amount of 0% to 0.05%;
- selenium in an amount of 0% to 0.05%;
- tellurium in an amount of 0% to 0.05%;
- zinc in an amount of 0% to 21.3%;
- silicon in an amount of 0% to 0.8%;
- aluminum in an amount of 0% to 8.5%;
- arsenic in an amount of 0% to 0.06%;
- beryllium in an amount of 0% to 2.1%;
- carbon in an amount of 0% to 0.05%;
- cobalt in an amount of 0% to 2.8%;
- iron in an amount of 0% to 3.5%;
- manganese in an amount of 0% to 1.5%;
- nickel in an amount of 0% to 32%;
- phosphorus in an amount of 0% to 0.4%;
- lead in an amount of 0% to 2.5%;
- sulfur in an amount of 0% to 0.05%;
- tin in an amount of 0% to 8.5%;
with respect to the weight of the metallic material;
- incidental impurities;
the rest being copper until the sum of the ingredients reaches 100% by weight with respect to the weight of the metallic material. Copper is the ingredient in the highest percentage by weight with respect to the weight of the metallic material.

In a particular embodiment, the metallic material comprises, and particularly consists of:
- silver in an amount of 0% to 0.015%;
- bismuth in an amount of 0% to 0.0005%;
- oxygen in an amount of 0% to 0.06%;
- lead in an amount of 0% to 0.005%;
- an amount of 0% to 0.03% of the sum by weight of arsenic, bismuth, cadmium, cobalt, chromium, iron, manganese, nickel, phosphorus, lead, sulfur, antimony, selenium, silicon, tin, tellurium, zinc;
with respect to the weight of the metallic material;
- incidental impurities;
the rest being copper until the sum of the ingredients reaches 100% by weight with respect to the weight of the metallic material. Copper is the ingredient in the highest percentage by weight with respect to the weight of the metallic material.

Specific non-limiting examples of the metallic material comprising copper that can be used in the context of the present invention are CW020A (Cu-PHC) according to the PD CEN/TS 13388:2020 standard.

These metallic materials are commercially accessible through various sellers, such as Wieland, Aurubis, KME.

In one embodiment, the metallic material comprising copper as defined in any of the preceding embodiments has a thermal conductivity at 20°C of at least 20, preferably at least 100, even more preferably at least 300 W/mK. More particularly, it has a thermal conductivity at 20°C of between 20, preferably 100, even more preferably 300 W/mK, and 400 W/mK.

### Metallic material comprising aluminum as the ingredient in the highest amount by weight

In a particular embodiment, the metallic material is a metallic material, preferably a metallic alloy, comprising aluminum as the ingredient in the highest amount by weight.

In a preferred embodiment, the metallic material comprises aluminum preferably in an amount of at least 80%, more preferably of at least 90%, even more preferably of at least 95%, still more preferably of at least 99%, by weight with respect to the weight of the metallic material. In one embodiment, the metallic material consists essentially of aluminum, more particularly it is aluminum.

In one embodiment, the rest of the percentage by weight, to reach 100% by weight with respect to the weight of the metallic material, comprises, or more particularly consists of:
- one or more elements selected from silicon, iron, copper, manganese, magnesium, chromium, nickel, zinc, titanium, gallium, vanadium, boron, lead, cobalt, bismuth, zirconium;
- incidental impurities.

In one embodiment, the metallic material, and particularly consists of:
- silicon in an amount of 0.006% to 13.5%;
- iron in an amount of 0.006% to 1.0%;
- copper in an amount of 0.003% to 1.3%;
- manganese in an amount of 0% to 2.0%;
- magnesium in an amount of 0% to 2.0%;
- chromium in an amount of 0% to 0.25%;
- nickel in an amount of 0% to 1.3%;
- zinc in an amount of 0% to 1.3%;
- titanium in an amount of 0% to 0.25%;
- gallium in an amount of 0% to 0.05%;
- vanadium in an amount of 0% to 0.05%;
- boron in an amount of 0% to 0.05%;
- lead in an amount of 0% to 0.10%;
- cobalt in an amount of 0% to 0.05%;
- bismuth in an amount of 0% to 0.2%;
- zirconium in an amount of 0% to 0.1%;
with respect to the weight of the metallic material;
- incidental impurities;
the rest being aluminum until the sum of the ingredients reaches 100% by weight with respect to the weight of the metallic material. Aluminum is the ingredient in the highest percentage by weight with respect to the weight of the metallic material.

In a particular embodiment, the metallic material comprises, and particularly consists of:
- silicon in an amount of 0.15% to 0.95%;
- iron in an amount of 0.10% to 0.95%;
- copper in an amount of 0.03% to 0.7%;
- manganese in an amount of 0.02% to 2.0%;
- magnesium in an amount of 0% to 0.05%;
- zinc in an amount of 0.06% to 0.1%;
- titanium in an amount of 0% to 0.25%;
- gallium in an amount of 0% to 0.03%;
- zirconium in an amount of 0% to 0.1%;
with respect to the weight of the metallic material;
- incidental impurities;
the rest being aluminum until the sum of the ingredients reaches 100% by weight with respect to the weight of the metallic material. Aluminum is the ingredient in the highest percentage by weight with respect to the weight of the metallic material.

Specific non-limiting examples of metallic material comprising aluminum that can be used in the context of the present invention are EN-AW 1050, 1080 and 1100, and EN-AW 3003 according to the UNE EN 573-3_2014-01 standard.

These metallic materials are commercially accessible through various sellers, such as Gränges, Speira GmbH.

In one embodiment, the metallic material comprising aluminum as the ingredient in the highest amount by weight with respect to the weight of the metallic material as defined in any of the preceding embodiments has a thermal conductivity at 20°C of at least 100, preferably at least 150 W/mK. More particularly, it has a thermal conductivity at 20°C of between 100, preferably 150 W/mK, and 220 W/mK.

In the present invention, the wall of the base, or the wall of the cover, or both, comprises, and particularly consists of, a structural metallic material which is selected from steel and a metallic material comprising aluminum as the ingredient in the highest amount by weight. In more particular embodiments, these materials are as defined above in the sections *"Metallic material: steel"* and *"Metallic material comprising aluminum as the ingredient in the highest amount by weight".*

The invention incorporates at least a part of structural metallic material extending a segment which, according to the longitudinal projection, defines a section with a specific distance. In turn, the projection of the exchange region, comprising the metallic heat transfer material, also according to the longitudinal direction, is within the section defined by the segment. This part of the structural metallic material causes greater stiffness in the segment without affecting the characteristics of the heat exchange region that keeps the configuration thereof adapted to transfer heat.

According to one embodiment, *the at least one segment of the part of the structural metallic material is such that a plurality of heat exchange regions are arranged between the ends of said segment according to the longitudinal direction.*

According to this embodiment, not only the at least one heat exchange region is located, according to the longitudinal direction, between the ends of the segment of the at least a part of the structural metallic material, rather a plurality (two or more) of heat exchange regions and according to their distribution according to the longitudinal direction, is located between the ends of the segment of the structural metallic material. In other words, the device is reinforced longitudinally as a whole along the entire length in which there are weakening elements, the exchange regions including the transitions or separations between said exchange regions.

According to a preferred embodiment applicable to all the described examples, *the wall of the base, of the cover, or of both, is a flat plate.*

The wall of the base, of the cover, or of both shall be interpreted as a flat plate when at least the portion of the wall belonging to the heat exchange region thereof extends along a plane. The plate is understood to be flat even if the surface thereof has a texture, or grooves, or ribs. This is the case of a surface that includes these elements for an improved fixing of pastes intended for improving thermal contact between surfaces while still being adapted to come into contact with flat electrical or electronic devices to be cooled.

This configuration allows adaptation to the conventional, also flat configuration of the surfaces to be cooled and furthermore facilitates manufacture even when combining more than a single material. The use of flat plates allows, for example, using cost-effective stamping techniques.

According to one embodiment applicable to all the described examples, the wall of the base, of the cover, or of both, comprises two different metallic materials, one of which is the structural metallic material, as already described above; and the other one of which is comprised in the at least one heat exchange region (R) and is referred to as a metallic heat transfer material.

According to this embodiment, the wall, which can be of the base, of the cover, or of both, is configured to be the element that withstands the bending imposed by the fixing means which can be, for example, external fixing means or fixing means belonging to the exchanger; to serve as a liquid barrier for the liquid coolant and particularly to favor heat exchange by conduction by means of the heat exchange regions (R).

According to this embodiment, although the use of metallic materials allows addressing two different combined functions, i.e., mainly a structural function and another heat transfer function, both metallic materials contributes to a lesser extent to the other function. For example, as described above, the steels used have a minimum thermal conductivity. Likewise, when a material has a structural function such as steel, the other metallic material can present a smaller wall thickness, greatly increasing heat transfer by reducing thermal resistance.

Furthermore, the case may arise where one and the same material provides both the desired structural resistance and the desired thermal conductivity to be considered both a structural metallic material and a metallic heat transfer material.

The at least one heat exchange region (R) comprises, and particularly consists of, a metallic heat transfer material. In a preferred embodiment, the metallic heat transfer material is selected from:
∘ steel, preferably carbon steel;
∘ a metallic material comprising copper as the ingredient in the highest amount by weight; and
∘ a metallic material comprising aluminum as the ingredient in the highest amount by weight.

In more particular embodiments, these materials are as defined above in the sections *"Metallic material: steel", "Metallic material comprising copper as the ingredient in the highest amount by weight",* and *"Metallic material comprising aluminum as the ingredient in the highest amount by weight".*

### Composition of the cover and base

According to embodiments which apply to all the preceding examples, the wall of the base comprises, and particularly consists of, a structural metallic material which is selected from:
- steel; and
- a metallic material comprising aluminum as the ingredient in the highest amount by weight.

According to embodiments which apply to all the preceding examples, the at least one heat exchange region (R) of the wall of the base comprises, and particularly consists of, a metallic heat transfer material which is selected from:
- steel, preferably carbon steel;
- a metallic material comprising copper as the ingredient in the highest amount by weight; and
- a metallic material comprising aluminum as the ingredient in the highest amount by weight;
and preferably selected from:
- a metallic material comprising copper as the ingredient in the highest amount by weight; and
- a metallic material comprising aluminum as the ingredient in the highest amount by weight.

According to embodiments which apply to all the preceding examples, the wall of the cover comprises, and particularly consists of, a structural metallic material which is selected from:
- steel; and
- a metallic material comprising aluminum as the ingredient in the highest amount by weight.

According to embodiments which apply to all the preceding examples, the at least one heat exchange region (R) of the wall of the cover comprises, and particularly consists of, a metallic heat transfer material which is selected from:
- steel;
- a metallic material comprising copper as the ingredient in the highest amount by weight; and
- a metallic material comprising aluminum as the ingredient in the highest amount by weight;
and preferably selected from:
- a metallic material comprising copper as the ingredient in the highest amount by weight; and
- a metallic material comprising aluminum as the ingredient in the highest amount by weight.

In one embodiment, the preceding embodiments referring to the structural metallic material and heat transfer in the base or the cover are combined.

In some embodiments, the structural metallic material is a material different from the metallic heat transfer material.

In some embodiments, the structural metallic material is a material different from the metallic heat transfer material but they are both selected from the same group of material, i.e., from the group of "steels" or the group of "metallic materials comprising aluminum as the ingredient in the highest amount by weight". For example, a stainless steel could be used as a structural metallic material and a carbon steel could be used as the metallic heat transfer material.

In some embodiments, the structural metallic material is the same material as the metallic heat transfer material. In other words, the same material has properties which make it suitable as a structural metallic material, and in turn as a heat transfer material. This is the case, for example, of aluminum or carbon steel. In these embodiments, being the same material, the at least one heat exchange region (R) can form a single part with the rest of the wall and it would not be necessary to attach them, for example by welding.

In a particular embodiment:
- the structural metallic material comprised in the wall of the base is a metallic material comprising aluminum as the ingredient in the highest amount by weight; and
- the metallic heat transfer material comprised in the at least one heat exchange region (R) of the wall of the base is a metallic material comprising copper as the ingredient in the highest amount by weight.

In a particular embodiment:
- the structural metallic material comprised in the wall of the base is steel; and
- the metallic heat transfer material comprised in the at least one heat exchange region (R) of the wall of the base is a metallic material comprising copper as the ingredient in the highest amount by weight.

In a particular embodiment:
- the structural metallic material comprised in the wall of the base is a metallic material comprising aluminum as the ingredient in the highest amount by weight; and
- the metallic heat transfer material comprised in the at least one heat exchange region (R) of the wall of the base is a metallic material comprising aluminum as the ingredient in the highest amount by weight.

In a particular embodiment:
- the structural metallic material comprised in the wall of the base is a metallic material comprising aluminum as the ingredient in the highest amount by weight; and
- the metallic heat transfer material comprised in the at least one heat exchange region (R) of the wall of the base is steel, preferably carbon steel.

In a particular embodiment:
- the structural metallic material comprised in the wall of the base is steel, preferably stainless steel; and
- the metallic heat transfer material comprised in the at least one heat exchange region (R) of the wall of the base is steel, preferably carbon steel.

In a particular embodiment:
- the structural metallic material comprised in the wall of the base is steel; and
- the metallic heat transfer material comprised in the at least one heat exchange region (R) of the wall of the base is a metallic material comprising aluminum as the ingredient in the highest amount by weight.

In additional embodiments, the preceding embodiments referring to the materials of the wall of the base refer alternatively to the materials of the wall of the cover.

In more particular embodiments, these materials are as defined above in the sections *"Metallic material: steel", "Metallic material comprising copper as the ingredient in the highest amount by weight",* and *"Metallic material comprising aluminum as the ingredient in the highest amount by weight".* Preferably, the metallic material comprising aluminum as the ingredient in the highest amount by weight is aluminum. Preferably, the metallic material comprising copper as the ingredient in the highest amount by weight is copper.

In additional embodiments, the materials of both the cover and the base are defined. This gives rise to different combinations described in the following groups:
- Groups in which both the wall of the base and the wall of the cover comprise a single material or different materials that act as a structural metallic material and a heat transfer material (Groups I to IV);
- Groups in which the wall of the base and/or the wall of the cover act solely as a structural metallic material or a heat transfer material (Groups Va and Vb).

### Group I

This group includes examples in which:
- the structural metallic material of the wall of the base;
- the structural metallic material of the wall of the cover;
- the metallic heat transfer material of the wall of the base;
- the metallic heat transfer material of the wall of the cover;
is the same material.

In an example of this group, this same material comprises aluminum as the ingredient in the highest amount by weight; particular embodiments which apply to this same material, which is preferably aluminum, have been described in the section *"Metallic material comprising aluminum as the ingredient in the highest amount by weight".* In an even more particular embodiment, both the wall of the cover and of the base and the at least one heat exchange region (R) of the wall of the cover and of the base consist of that same material which is aluminum. Preferably, in this example, the cover is attached to the base by soldering.

In a preferred embodiment of the preceding example, the dissipating fins do not comprise a material comprising aluminum as the ingredient in the highest amount by weight; preferably they are not made of aluminum; more preferably comprise a material comprising copper as the ingredient in the highest amount by weight; even more preferably they are made of copper. Preferably, the dissipating fins are attached to the cover, to the wall, or to both, by soldering.

In an example of this group, this same material is steel; particular embodiments of steel materials which apply to this same material of the present application have been described in the section *"Metallic material: steel".* In an even more particular embodiment, both the wall of the cover and of the base and the at least one heat exchange region (R) of the wall of the cover and of the base consist of that same material which is steel.

### Group II

This group includes examples in which:
- the structural metallic material of the wall of the base, and
- the metallic heat transfer material of the wall of the base;

is the same metallic material; and
   - the structural metallic material of the wall of the cover, and
   - the metallic heat transfer material of the wall of the cover
is the same metallic material;
but that metallic material of the wall of the cover is different of that metallic material of the wall of the base. Said walls may comprise, particularly consist of, said materials.

In an example of this group, the metallic material of the wall of the cover is selected from steel; and a metallic material comprising aluminum as the ingredient in the highest amount by weight.

In an example of this group, the metallic material of the wall of the base is selected from steel; and a metallic material comprising aluminum as the ingredient in the highest amount by weight.

In one example, that same material in the wall of the cover is a metallic material comprising aluminum as the ingredient in the highest amount by weight, whereas in the wall of the base it is a metallic material comprising steel.

In another preferred example, that same material in the wall of the cover is steel, whereas in the wall of the base it is a metallic material comprising aluminum as the ingredient in the highest amount by weight. In particular embodiments, steels and metallic materials comprising aluminum as the ingredient in the highest amount by weight are as described above in the sections *"Metallic material: steel"* and *"Metallic material comprising aluminum as the ingredient in the highest amount by weight"* and also apply to the examples of group II. Preferably, the metallic material comprising aluminum as the ingredient in the highest amount by weight is aluminum.

In one embodiment, when the metallic material of the wall of the base, and the metallic material of the wall of the cover which is different, are both chosen from the group of metallic materials comprising aluminum as the ingredient in the highest amount by weight, the cover is attached to the base by soldering.

In a preferred embodiment of the preceding example, the dissipating fins do not comprise a material comprising aluminum as the ingredient in the highest amount by weight; preferably they are not made of aluminum; more preferably they comprise a material comprising copper as the ingredient in the highest amount by weight; even more preferably they are made of copper. Preferably, the dissipating fins are attached to the cover, to the wall, or to both, by soldering.

### Group III

This group includes examples in which the wall of the cover or the wall of the base comprises, and particularly consists of, one and the same metallic material which is both the structural metallic material and the heat transfer material; whereas the other wall comprises, particularly consists of, two different metallic materials (one structural material and one heat transfer material).

In some examples of group III, the wall of the cover comprises steel or a metallic material comprising aluminum as the ingredient in the highest amount by weight as the same metallic material (structural material and heat transfer material in the at least one heat exchange region (R)).

In some examples of group III, the wall of the base comprises steel or a metallic material comprising aluminum as the ingredient in the highest amount by weight as the same metallic material (structural material and heat transfer material).

Additional or alternatively, in the wall of the cover or of the base comprising two different materials, the at least one heat exchange region (R) comprises a metallic heat transfer material selected from a metallic material comprising copper as the ingredient in the highest amount by weight; or a metallic material comprising aluminum as the ingredient in the highest amount by weight; with the structural metallic material being steel or a metallic material comprising aluminum as the ingredient in the highest amount by weight.

In an example of group III:
- the wall of the cover comprises steel as the metallic material (structural material and heat transfer material); and
- the wall of the base comprises a metallic heat transfer material comprising copper as the ingredient in the highest amount by weight in the at least one heat exchange region (R) and steel as a structural metallic material.

In a specific example of group III:
- the wall of the cover comprises steel as the metallic material (structural material and heat transfer material); and
- the wall of the base comprises a metallic heat transfer material comprising aluminum as the ingredient in the highest amount by weight in the at least one heat exchange region (R) and steel as a structural metallic material.

In a specific example of group III:
- the wall of the cover comprises a metallic material (structural material and heat transfer material) comprising aluminum as the ingredient in the highest amount by weight; and
- the wall of the base comprises a metallic heat transfer material comprising copper as the ingredient in the highest amount by weight in the at least one heat exchange region (R) and a structural metallic material comprising aluminum as the ingredient in the highest amount by weight.

In a specific example of group III:
- the wall of the base comprises steel as the metallic material (structural material and heat transfer material); and
- the wall of the cover comprises a metallic heat transfer material comprising copper as the ingredient in the highest amount by weight in the at least one heat exchange region (R) and steel as a structural metallic material.

In a specific example of group III:
- the wall of the base comprises steel as the metallic material (structural material and heat transfer material); and
- the wall of the cover comprises a metallic heat transfer material comprising aluminum as the ingredient in the highest amount by weight in the at least one heat exchange region (R) and steel as a structural metallic material.

In a specific example of group III:
- the wall of the base comprises a metallic material (structural material and heat transfer material) comprising aluminum as the ingredient in the highest amount by weight; and
- the wall of the cover comprises a metallic heat transfer material comprising copper as the ingredient in the highest amount by weight in the at least one heat exchange region (R) and a structural metallic material comprising aluminum as the ingredient in the highest amount by weight.

In more particular embodiments, these materials are as defined above in the sections *"Metallic material: steel", "Metallic material comprising copper as the ingredient in the highest amount by weight",* and *"Metallic material comprising aluminum as the ingredient in the highest amount by weight".* Preferably, the metallic material comprising aluminum as the ingredient in the highest amount by weight is aluminum. Preferably, the metallic material comprising copper as the ingredient in the highest amount by weight is copper.

### Group IV

This group includes examples in which both the wall of the cover and the wall of the base comprise a structural metallic material different from the metallic heat transfer material.

In some examples of group IV, both the wall of the cover and the wall of the base comprise, particularly consist of, a metallic heat transfer material in the at least one heat exchange region (R) selected from a metallic material comprising copper as the ingredient in the highest amount by weight, and a metallic material comprising aluminum as the ingredient in the highest amount by weight; and a structural metallic material selected from a metallic material comprising aluminum as the ingredient in the highest amount by weight, and steel.

In a preferred example of group IV:
- the wall of the cover comprises i) a metallic heat transfer material comprising copper as the ingredient in the highest amount by weight in the at least one heat exchange region (R) and ii) steel as a structural metallic material; and
- the wall of the base comprises i) a metallic heat transfer material comprising copper as the ingredient in the highest amount by weight in the at least one heat exchange region (R) and ii) steel as a structural metallic material.

In a preferred example of group IV:
- the wall of the cover comprises i) a metallic heat transfer material comprising copper as the ingredient in the highest amount by weight in the at least one heat exchange region (R) and ii) a structural metallic material comprising aluminum as the ingredient in the highest amount by weight; and
- the wall of the base comprises i) a metallic heat transfer material comprising copper as the ingredient in the highest amount by weight in the at least one heat exchange region (R) and ii) a structural metallic material comprising aluminum as the ingredient in the highest amount by weight.

In a preferred example of group IV:
- the wall of the cover comprises i) a metallic heat transfer material comprising aluminum as the ingredient in the highest amount by weight in the at least one heat exchange region (R) and ii) steel as a structural metallic material; and
- the wall of the base comprises i) a metallic heat transfer material comprising aluminum as the ingredient in the highest amount by weight in the at least one heat exchange region (R) and ii) steel as a structural metallic material.

In more particular embodiments, these materials are as defined above in the sections *"Metallic material: steel", "Metallic material comprising copper as the ingredient in the highest amount by weight",* and *"Metallic material comprising aluminum as the ingredient in the highest amount by weight".* Preferably, the metallic material comprising aluminum as the ingredient in the highest amount by weight is aluminum. Preferably, the metallic material comprising copper as the ingredient in the highest amount by weight is copper.

### Group V

This group includes embodiments in which the wall of the base or of the cover comprises a heat exchange region (R) but not a structural metallic material, or a structural metallic material but not a heat exchange region (R).

### Group Va)

This group includes embodiments in which the wall of the base or of the cover comprises a heat exchange region (R) but not a structural metallic material, particularly consists of a heat exchange region (R).

Preferably, the wall of the cover or the base comprises a heat exchange region (R) but not a structural metallic material, and the other wall comprises a structural metallic material but not a heat exchange region (R). In one embodiment, it is the wall of the cover which does not comprise a structural metallic material. In an alternative embodiment, it is the wall of the base which does not comprise a structural metallic material.

Alternatively, the wall of the cover or the base comprises a heat exchange region (R) but not a structural metallic material, and the other wall comprises a heat exchange region (R) and a structural metallic material. In one embodiment, it is the wall of the cover which does not comprise a structural metallic material. In an alternative embodiment, it is the wall of the base which does not comprise a structural metallic material.

In a preferred particular embodiment, the wall of the cover or the base:
- comprises at least one heat exchange region (R) comprising, particularly consisting of, a metallic heat transfer material comprising copper as the ingredient in the highest amount by weight;
- but does not comprise a structural metallic material; and
the other wall comprises a structural metallic material, and more particularly comprises a structural metallic material but not a heat exchange region (R), and more particularly consists of a structural metallic material, wherein this structural metallic material preferably:
- comprises aluminum as the ingredient in the highest amount by weight; or
- is steel.

In a particular embodiment, this structural metallic material comprises aluminum as the ingredient in the highest amount by weight. In an alternative particular embodiment, this structural metallic material is steel.

In a more particular embodiment of the foregoing, it is the wall of the cover which does not comprise a structural metallic material. Alternatively, it is the wall of the base which does not comprise a structural metallic material.

### Group Vb)

This group includes embodiments in which the wall of the base or of the cover comprises, particularly consists of, a structural metallic material but not a heat exchange region (R).

In a particular embodiment, it is the wall of the cover which does not comprise a heat exchange region (R). In an alternative particular embodiment, it is the wall of the base which does not comprise a heat exchange region (R).

In one embodiment, the wall of the base or the cover comprises, particularly consists of, a structural metallic material but not a heat exchange region (R); and the other wall comprises, particularly consists of, a structural metallic material and at least one heat exchange region (R). In a particular embodiment, it is the wall of the cover which does not comprise a heat exchange region (R). In an alternative particular embodiment, it is the wall of the base which does not comprise a heat exchange region (R).

In a particular embodiment:
- the wall of the cover comprises steel as the metallic purely structural material; and
- the wall of the base comprises a metallic heat transfer material comprising copper as the ingredient in the highest amount by weight in the at least one heat exchange region (R) and steel as a structural metallic material.

In a particular embodiment:
- the wall of the cover comprises steel as the metallic purely structural material; and
- the wall of the base comprises a metallic heat transfer material comprising aluminum as the ingredient in the highest amount by weight in the at least one heat exchange region (R) and steel as a structural metallic material.

In a particular embodiment:
- the wall of the cover comprises a metallic purely structural material comprising aluminum as the ingredient in the highest amount by weight; and
- the wall of the base comprises a metallic heat transfer material comprising copper as the ingredient in the highest amount by weight in the at least one heat exchange region (R) and a structural metallic material comprising aluminum as the ingredient in the highest amount by weight.

In a particular embodiment:
- the wall of the base comprises steel as the metallic purely structural material; and
- the wall of the cover comprises a metallic heat transfer material comprising copper as the ingredient in the highest amount by weight in the at least one heat exchange region (R) and steel as a structural metallic material.

In a particular embodiment:
- the wall of the base comprises steel as the metallic purely structural material; and
- the wall of the cover comprises a metallic heat transfer material comprising aluminum as the ingredient in the highest amount by weight in the at least one heat exchange region (R) and steel as a structural metallic material.

In a particular embodiment:
- the wall of the base comprises a metallic purely structural material comprising aluminum as the ingredient in the highest amount by weight; and
- the wall of the cover comprises a metallic heat transfer material comprising copper as the ingredient in the highest amount by weight in the at least one heat exchange region (R) and a structural metallic material comprising aluminum as the ingredient in the highest amount by weight.

In more particular embodiments, these materials are as defined above in the sections "Metallic material: steel", "Metallic material comprising copper as the ingredient in the highest amount by weight", and *"Metallic material comprising aluminum as the ingredient in the highest amount by weight".* Preferably, the metallic material comprising aluminum as the ingredient in the highest amount by weight is aluminum. Preferably, the metallic material comprising copper as the ingredient in the highest amount by weight is copper.

In preferred examples of groups I-V, when the wall and/or the exchange region R in the cover and/or in the base comprise aluminum as the ingredient in the highest amount by weight according to any of the preceding embodiments, said wall and exchange region are attached by soldering.

When the wall of the cover and/or the wall of the base is attached to dissipating fins, in examples which apply to all the groups I-V, said fins comprise, and particularly consist of, a metallic material comprising copper as the ingredient in the highest amount by weight. In more particular embodiments, this material is as defined above in the section *"Metallic material comprising copper as the ingredient in the highest amount by weight".* Preferably, the metallic material comprising copper as the ingredient in the highest amount by weight is copper.

When the wall of the cover and/or the wall of the base is attached to dissipating fins, in examples which apply to all the groups I-V, said fins comprise, and particularly consist of, a metallic material comprising aluminum as the ingredient in the highest amount by weight. In more particular embodiments, this material is as defined above in the section *"Metallic material comprising aluminum as the ingredient in the highest amount by weight".* Preferably, the metallic material comprising aluminum as the ingredient in the highest amount by weight is aluminum.

According to an embodiment applicable to any of the foregoing, *the heat exchange region is a continuous region adapted to receive the plurality of electronic devices.*

This embodiment is preferred since it maintains a reinforced part in the structural metallic material, for example a perimeter frame, and furthermore a single continuous region which can be made, according to a specific embodiment, in a single part located inside the perimeter frame. The simplicity of this embodiment reduces the operations required for the manufacture thereof and the possibility of the appearance of defects both in manufacture and with use.

According to one embodiment, the part of the structural metallic material is the one responsible for increasing resistance, whereas the heat exchange regions are made of any metallic heat transfer material, without necessarily having to have a large thickness to withstand resistant stresses. This allows their thickness to be less than if the entire base were made of one and the same material with good heat conduction properties.

The thickness of the heat exchange region and of non-heat exchange regions of the wall according to an embodiment is the same. The manufacture of this configuration is simpler and allows the heat exchange regions to also be able to absorb stresses due to internal pressure in the chamber.

### Methods and materials for attaching different metallic materials

According to one embodiment, *the attachment between the metallic heat transfer material, in the at least one heat exchange region (R) and the perimeter metallic material which is not the heat exchange region of the wall,* i.e., the structural metallic material, *is established through expansion by means of the pressing of the metallic material of the exchange region.*

A specific configuration shows a base formed by a wall formed by a structure made of a structural metallic material extending longitudinally on both sides, as well as in transverse segments, leaving internal regions in the form of islands. These internal regions, the heat exchange regions, are made of the metallic heat transfer material.

In another embodiment applicable to any preceding example, where the metallic heat transfer material of the heat exchange region (R) and the structural metallic material are different, *the attachment between the metallic heat transfer material of the exchange region and the perimeter structural metallic material which is not the exchange region of the wall of the base is obtained by leak-tight sealing through an attachment material.* To that end, an attachment material can be arranged between the metallic heat transfer material and the perimeter structural metallic material which is not the exchange region of the wall of the base. Preferably, the attachment material is a metal for welding or an adhesive. This embodiment is particularly useful for sealing the attachment in more demanding situations.

Therefore, the present invention also relates to an *exchanger* as described in any embodiment described herein, *comprising an attachment material between the metallic heat transfer material and the perimeter structural metallic material which is not the exchange region of the wall of the base, of the wall of the cover, or of both.*

Specific non-limiting examples of adhesive are acrylic adhesives, particularly cyanoacrylic, epoxy, anaerobic, or silicone adhesives.

In the case of the metal for welding (or metal suitable for welding), it is a metal having a melting temperature that is less than the melting temperature of the metallic heat transfer material of the exchange region and the melting temperature of the perimeter structural metallic material which is not the exchange region of the wall of the base, of the wall of the cover, or of both. Before melting by welding, the metal for welding can be in the form of a paste, sheet, rods, or wire, preferably in the form of a sheet or paste.

The metal for welding can first be arranged between the metallic heat transfer material of the heat exchange region (R) and the perimeter structural metallic material. The subsequent melting of the metal for welding during the welding process causes the attachment of the metallic heat transfer material of the exchange region and the perimeter structural metallic material by capillary attraction, and the subsequent solidification of the metal for welding after cooling gives rise to the aforementioned leak-tight sealing. According to one example, the welding is carried out during passage through the furnace when all the parts are welded using brazing . Therefore, in one embodiment, the metal for welding is a metal for brazing.

In one embodiment, the metal for welding is an alloy. The metal for welding is often chosen based on the metal to be welded.

In the case where the metallic heat transfer material of the heat exchange region (R) is a metal comprising copper, preferably as the main component by weight, as described in any preceding embodiment, the metal for welding can be selected from alloys comprising, and particularly consisting of: copper; and one or more of nickel, tin, phosphorus, zinc, oxygen, silicon, iron, manganese and silver; and incidental impurities; wherein copper, or copper or silver, in the case where the latter is present, is the main ingredient by weight with respect to the weight of the metal for welding.

In one embodiment, the metal for welding comprises, and particularly consists of:
- nickel in an amount of 0% to 7%,
- tin in an amount of 0% to 10%,
- phosphorus in an amount of 0% to 7.8%,
- zinc in an amount of 0% to 48%,
- oxygen in an amount of 0% to 0.05%,
- silicon in an amount of 0% to 0.3%,
- iron in an amount of 0% to 2.5%,
- manganese in an amount of 0% to 2.5%,
- silver in an amount of 0% to 72%,
with respect to the weight of the metal for welding;
- incidental impurities;
- the rest being copper until the sum of the ingredients reaches 100% by weight with respect to the weight of the metal for welding,
wherein copper, or copper or silver, in the case where the latter is present, is the main ingredient by weight with respect to the weight of the metal for welding.

In a particular embodiment, the metal for welding comprises, and particularly consists of:
- nickel in an amount of 0% to 7%,
- tin in an amount of 0% to 10%,
- phosphorus in an amount of 0% to 7.8%,
- zinc in an amount of 0% to 48%,
- oxygen in an amount of 0% to 0.05%,
with respect to the weight of the metal for welding;
- incidental impurities;
- the rest being copper until the sum of the ingredients reaches 100% by weight with respect to the weight of the metal for welding,
wherein copper is the main ingredient by weight with respect to the weight of the metal for welding.

Specific non-limiting examples of tales metals for welding are DIN EN 1044: 2006-08 CU 301, CU 306, CP 201, CP 202, CP 203, CP 302, CP 105, CP 102, CP 101, AG 206, AG 401, AG 203, AG 103, AG 402, AG 104, AG 204.

In the case where the metallic heat transfer material of the exchange region is a metal comprising aluminum as the main component by weight, as described in any preceding embodiment, the metal for welding can be selected from alloys comprising, and particularly consisting of: aluminum; and one or more of silicon, iron, copper, manganese, magnesium, chromium, nickel, zinc, titanium, cobalt, bismuth; and incidental impurities; wherein aluminum is the main ingredient by weight with respect to the weight of the metal for welding.

In one embodiment, the metal for welding comprises, and particularly consists of:
- silicon in an amount of 0.6% to 13.5%,
- iron in an amount of 0.2% to 1.0%,
- copper in an amount of 0.05% to 1.3%,
- manganese in an amount of 0% to 1.5%,
- magnesium in an amount of 0% to 2.0%,
- chromium in an amount of 0% to 0.25%,
- nickel in an amount of 0% to 1.3%,
- zinc in an amount of 0.05% to 1.3%,
- titanium in an amount of 0% to 0.2%,
- cobalt in an amount of 0% to 0.05%,
- bismuth in an amount of 0% to 0.2%,
with respect to the weight of the metal for welding;
- incidental impurities;
- the rest being aluminum until the sum of the ingredients reaches 100% by weight with respect to the weight of the metal for welding,
wherein aluminum is the main ingredient by weight with respect to the weight of the metal for welding.

In a particular embodiment, the metal for welding comprises, and particularly consists of:
∘ silicon in an amount of 0.6% to 13.5%,
∘ iron in an amount of 0.2% to 1.0%,
∘ copper in an amount of 0.05% to 1.3%,
∘ manganese in an amount of 0.05% to 1.5%,
∘ magnesium in an amount of 0% to 2.0%,
∘ zinc in an amount of 0.05% to 1.3%,
∘ titanium in an amount of 0% to 0.2%,
with respect to the weight of the metal for welding;
- incidental impurities;
- the rest being aluminum until the sum of the ingredients reaches 100% by weight with respect to the weight of the metal for welding,
wherein aluminum is the main ingredient by weight with respect to the weight of the metal for welding.

Specific non-limiting examples of such metals for welding are the 4000 series Al Si according to the UNE EN 573-3_2014-01_EN standard.

In the case where the metallic heat transfer material of the exchange region is a metal comprising aluminum as the main component by weight, as described in any preceding embodiment, it is also possible to use metals for welding which do not comprise aluminum or which do not comprise aluminum as the main ingredient by weight with respect to the weight of the metal for welding, for example metals for welding comprising tin, zinc, or copper, more particularly with one of the first two being the main ingredient by weight with respect to the weight of the metal for welding. Examples of such materials are DIN EN ISO 3677:2017 S-Sn60Zn40, S-Sn90Zn7Cu3, S-Zn98Al2, S-Zn97Al3, S-ZnAl22-420/480.

Metals for welding are commercially available through sellers, such as voestalpine BöhlerWelding, Lucas Milhaupt.

In the case of using a sheet as a metal for welding, this is preferably first arranged on the metallic heat transfer material of the exchange region. In this arrangement, the sheet of metal for welding is often referred to as a clad. There are different cladded products of this type on the market, such as the material Trillium from the supplier Gränges. The sheet of metal for welding thus arranged is then contacted with the perimeter structural metallic material which is not the exchange region, and finally welding is performed, for example, as described above.

The sheet of metal for welding can be arranged on the metallic heat transfer material of the at least one exchange region in different manners known in the art, for example, by means of attachment through lamination, spraying, or through semi-continuous or continuous casting processes.

In one embodiment, during the welding attachment process, in addition to the metal for welding, a flux for welding is additionally used. Fluxes for welding are compounds which protect the metals to be welded from oxidation during a welding process. These fluxes for welding can be added in different manners: as powder, paste, or liquid (by spraying). In one embodiment, the flux for welding is applied on the surface of the metal for welding. In another embodiment, the flux for welding is embedded in the metal for welding such as, for example, in the case of the aforementioned Trillium material.

In the case where the structural metallic material is a metal comprising aluminum as the main component by weight, the welding is preferably soldering. Soldering is carried out at a temperature below 427°C (800°F) and below the melting point of the parts to be welded. Metals for weak welding are extensively known by one skilled in the art and include compositions comprising lead, tin, antimony, cadmium, or zinc.

According to an embodiment applicable to any of the described above, *the cover is made of a sheet metal and comprises a larger flat surface limited along the perimeter by a perimeter wall, wherein the perimeter wall of the cover is fixed to the base.*

This configuration allows establishing an essentially flat configuration of the heat exchanger. The perimeter walls of the cover increase resistance against bending, mainly longitudinal resistance, by increasing the moment of inertia according to a transverse axis. The attachment to the base causes the base - cover assembly to constitute a more resistant element since the fixing, for example by welding, between both parts will mainly absorb shear stresses in the presence of bending stress.

According to an embodiment applicable to any of the described above, *the exchanger further comprises one or more fin blocks for heat exchange arranged inside the chamber for the passage of the coolant.*

In this embodiment, the fin block or blocks are preferably attached to the surface opposite the wall having on the opposite surface thereof contact with the device to be cooled. When there are several heat exchange regions, the blocks are preferably located coinciding in position with the position of the devices to be cooled located on the opposite face of the wall through which heat transfer by conduction is established. This configuration optimizes heat transfer by convection from the wall to the liquid coolant right in the regions which receive a larger amount of heat by conduction through the wall.

According to a specific example of the preceding example, *the at least one fin block for heat exchange is attached to the inner area of the wall of a heat exchange region and is separated from the internal surface of the chamber located opposite, that is, if the fin block is attached to the wall of the base then it is separated from the cover and, if the fin block is attached to the wall of the cover then it is separated from the base.*

According to this specific example, attachment is established with a surface, for example, the wall of the base, but not with the internal wall of the cover, reducing the attachment to a weld with one surface but not with the other. This is possible given that the part of the structural metallic material which is responsible for longitudinal bending stiffness may not require additional stiffening elements, reducing manufacturing complication and its costs. If furthermore both the base and the cover include at least a part of the structural metallic material, then both parts, which are not connected through an intermediate body such as the fin block, are capable of absorbing expansion stresses caused by the higher pressure inside the chamber with respect to the atmospheric pressure.

According to another specific embodiment, which is an alternative to the embodiment immediately above, *the at least one fin block for heat exchange is attached to the inner area of the wall of a heat exchange region and is also attached to the internal surface of the chamber located opposite.*

This specific configuration establishes a mechanical linkage between the opposite surfaces on the inside of the chamber such that the wall of the base and the wall of the cover allow high internal pressures without the occurrence of, for example, deformations, buckling, or giving rise to a swelling effect.

According to an embodiment applicable to any of the described above, *the cover is made of a sheet metal and comprises a larger flat surface, wherein it further comprises the at least one heat exchange region (R).*

The heat exchanger has a base and a cover, both parts can be configured to exchange heat with the electrical or electronic devices to be cooled; however, according to this example, it is the cover which establishes heat exchange. A specific condition of use of the exchanger establishes heat exchange both through the wall of the base and of the cover, achieving a very high degree of compaction between the devices to be cooled and the heat exchanger or exchangers.

According to an embodiment applicable to any of the described above, *wherein the segment of the structural metallic material is a side wall of the cover.*

The example in which, at least the perimeter region of the part having at least a part of the structural metallic material extending along the longitudinal direction or at least up to where they are located proximal to the inlet port and the outlet port of the liquid coolant, is of particular interest. It is in this area, according to the longitudinal direction, where the bending stresses generate deformations that affect more the areas where heat exchange occurs, causing a reduction of the conditions of good heat transfer between contacting surfaces, between the exchanger and the device or devices to be cooled.

The wall of the cover according to a section transverse to the longitudinal direction shows segments extending away from the position of resistant elements out of the neutral line when the exchanger is subjected to bending, and therefore increasing the transverse moment of inertia; that is, it causes the assembly to be stiffer against bending.

According to an embodiment applicable to any of the described above, *the inlet port, the outlet port, or both ports comprise a compressible sealing gasket adapted to be pressed by means of compression forces in order to establish the leaktightness of the connection with the corresponding port.*

The sealing gasket ensures sealing in order to prevent the exit of the liquid coolant. According to preferred embodiments, the sealing gasket is made of an elastically deformable material, for example, an elastomeric material, which is compressed by the action of the fixing means.

In turn, the response of the sealing gasket as a result of its compression is to respond with a force that is opposite the force exerted by the fixing means. This response generates forces at the points where the inlet and outlet ports are located, generally at the ends of the resistant element, the base, the cover, or both. If the fixing means are located, for example, between these end points and distributed longitudinally, then the opposing forces of the fixing means cause bending stresses in the resistant element. The bending stresses must be supported by the part of the structural metallic material which acts to reduce bending deformation.

According to an embodiment applicable to any of the preceding examples, *the heat exchanger comprises fixing means configured to exert a force with a direction transverse to the wall of the base.*

According to the state of the art, parts such as the base or the cover comprise materials with good thermal conduction properties. However, to improve contact between the surface to be cooled and the surface coolant, fixing means which exert a force transverse to the base that must be structurally supported by the heat exchanger can be included. These stresses of the fixing means result in bending stresses that must be structurally supported by the heat exchanger, which gives rise to larger thicknesses which drastically reduce heat transfer by conduction.

Examples of fixing means are perforations in the base for the passage of bolts or screws intended for exerting a force perpendicular to the base. Other fixing means are clamps which perform anchoring along one or more longitudinal segments. These clamps and other fixing means according to some examples are releasable in order to better maintain the exchanger or the elements to be cooled.

According to another more specific embodiment with respect to the fixing means, *the fixing means are distributed according to the longitudinal direction with one or more attachment elements coinciding with the inlet port, with the outlet port, and at least one attachment means located between the two preceding ones.*

According to this embodiment, a compressive stress is ensured at the inlet and/or outlet and also at least one intermediate point which minimizes bending by generating several nodes of the bending deformation.

Fixing means based on the use of bolts preferably places the bolts along the of the chamber formed between the base and the cover.

A second inventive aspect relates to *a heat exchanger module, comprising at least two adjacent heat exchangers according to the preceding embodiment, wherein:*
- *the two or more heat exchangers are adapted to receive one or more electrical or electronic devices to be cooled interposed between two adjacent heat exchangers and in thermal contact with the heat exchange regions of both heat exchangers,*
- *it comprises fixing means pressing the one or more electrical or electronic devices to be cooled together, and*
- *the fixing means press the compressible sealing gaskets together.*

### DESCRIPTION OF THE DRAWINGS

These and other features and advantages of the invention will be shown more clearly based on the following detailed description of a preferred embodiment, provided solely by way of illustrative and non-limiting example in reference to the attached figures:
- Figure 1: This figure schematically shows a front view of a first embodiment of a heat exchanger of the invention attached to a plurality of electronic devices cooled in the operating mode by the heat exchanger.
- Figure 2: This figure schematically shows the top view of the same first embodiment.
- Figure 3: This figure schematically shows the top view of a second embodiment in which the exchange regions are in the cover.
- Figure 4: This figure schematically shows the front view of the second example shown in the preceding figure.
- Figure 5: This figure schematically shows a top view of an embodiment of a base with a plurality of exchange regions made of a material different from that of the rest of the base.
- Figure 6: This figure schematically shows the top view of an example such as the one shown in Figure 5 with the exception that there is a single exchange region which allows cooling a plurality of elements to be cooled.
- Figure 7: This figure schematically shows, according to a section of the front view of the base, the example shown in Figure 5.
- Figure 8: This figure schematically shows a second embodiment of a module formed by the combination of two heat exchangers such as the one shown in the two preceding figures, in which the plurality of electronic devices are located like sandwich between the two exchangers.

### DETAILED DESCRIPTION OF THE INVENTION

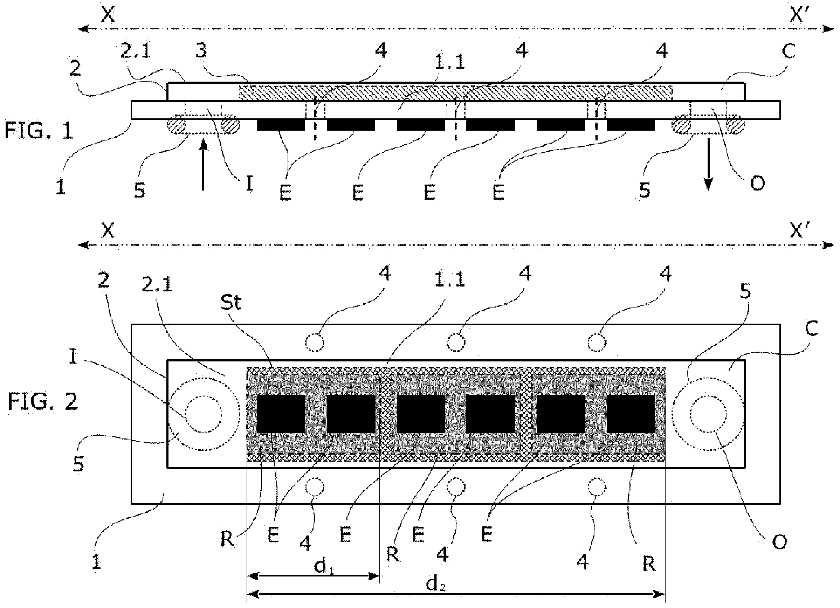

According to the first inventive aspect, the present invention relates to a device for evacuating heat from one or more electrical or electronic devices (E). Hereinafter, whenever electronic device (E) is indicated, it shall be understood that it can also be an electrical device (E). Figure 1 shows a front view of the first embodiment of the invention and this very embodiment is shown in a top view in Figure 2.

Both figures show a plurality of electronic devices (E) distributed according to a longitudinal direction X-X' either individually or according to rows of two or more electronic devices (E) likewise distributed according to the longitudinal direction (X-X').

The heat exchanger comprises a base (1) having an inlet port (I) for a liquid coolant and an outlet port (O) for a liquid coolant to allow the circulation of the liquid which serves to remove heat evacuated by the electronic devices (E) when the heat exchanger is in the operating mode.

Considering the arrangement shown in Figure 1, while the electronic devices (E) are arranged below the base (1), on the outer surface of a wall (1.1) of the base (1), above the same wall (1.1) is the opposite surface on which there is a cover (2) that forms a chamber (C). The liquid coolant circulates through the chamber (C).

Although the base (1) shows a wall (1.1) with a large thickness depicted by a horizontal rectangle, the wall (2.1) of the cover (2) is thinner and depicted by means of a thick line. In this embodiment, the wall (1.1) of the base (1) is a thick plate and the wall (2.1) of the cover (2) is sheet metal which has been stamped to form the cover (2).

Indication of being below or above, as positional references, should be interpreted considering the spatial arrangement shown in the figure given that the device can be in any position and orientation in the operating mode. Relative terms such as these and others such as right, left may be used in the description, it being understood that positional references with respect to the figure may likewise refer to the arrangement relative to one or more elements of the device taken as positional reference with respect to other elements also shown in the figure.

Considering Figure 1 and Figure 2, it can be seen that the cover (2) according to this embodiment has a length according to the longitudinal direction X-X' such that the inlet port (I) and the outlet port (O) have direct access to the inside of the chamber (C) because the distance between ports (I, O) is smaller than the length of the cover (2). In this way, the electronic devices (E) are distributed also between the inlet port (I) and the outlet port (O) on a side of the wall (1.1) of the base (1), or one or more fin blocks (3) for heat dissipation are arranged on the other side of the same wall (1.1).

The fin block or blocks (3) for heat dissipation are located in the internal wall of the chamber (C) and in a region (R) in which the electronic devices are located on the other side of the wall (1.1). This region is the region (R) that will be referred to as a heat exchange region given that it is the region in which heat transfer by conduction through the material of the wall (1.1) occurs.

The minimum size of a heat exchange region (R) corresponds to the projection of the contact area with the electrical or electronic device (E) according to a direction perpendicular to the wall (1.1, 2.1) where the heat exchange region (R) is located. However, once the electrical or electronic device (E) give off heat to the wall, heat conduction is not only according to the direction perpendicular to the wall, but also to a larger extent transverse, if the wall (1.1, 2.1) is thick. This means that, according to preferred examples, the heat exchange region (R) is more extensive than the minimum region as shown in Figure 2 in which the use of a heat conducting material in an area in which there are two electrical or electronic devices per heat exchange region (R) has been envisaged.

It is also considered relevant to clarify that although the electronic devices are depicted by means of a rectangle in the figures and that the entire contact area is also considered to be the area in which the electronic device (E) conducts heat, it is possible to use electronic devices (E) having more extensive contact bases with respect to the regions that actually generate heat. In these cases, the surface of the electronic device (E) is considered to have a limited extension with respect to the region in which heat is generated given that the rest of the base of the electronic device (E) only performs a structural function or another different function.

In other examples, the contact between the electronic device (E) and the heat exchanger is through a contact paste for heat exchange which is also limited to a specific region, leaving the rest of the area of the electronic device (E) without thermal conduction continuity with the heat exchanger. In these cases, it shall be interpreted that the electronic device (E) has a heat generating region limited to the region in which there is thermal conduction continuity, in this case, the region in which the contact paste for heat exchange extends.

These same Figures 1 and 2 show perforations that serve for the passage of fixing bolts (4) as fixing means, particularly bolts which press the wall (1.1) of the base (1) against the electronic devices (E), favoring a good contact between surfaces which improves heat transfer.

Likewise, Figure 1 shows a sealing gasket (5) surrounding the inlet port (I) and a sealing gasket (5) surrounding the outlet port (O). The force exerted by the fixing means (4) not only increase the pressure between the wall (1.1) and the electronic devices (E) but cause the compression of the sealing gaskets (5), ensuring the leak-tight sealing in the inlet port (I) and the outlet port (O).

The compression of the sealing gaskets (5) gives rise to a force on the base (1) perpendicular to the wall (1.1) of the base (1), vertical according to the orientation of Figure 1 and upwards, contributing to the bending stresses given also the reactions of the fixing means (4).

In the embodiment, for example, the fixing means (4) are distributed between the sealing gaskets (5) considering the longitudinal direction X-X', so the fixing means (4) exert a downward force in the intermediate area that is opposite the force exerted by the sealing gaskets (5).

This force composition causes a significant bending moment which generates deformations particularly in the central area of the heat exchanger, and the deformations, when occur, give rise to the separation between the electronic devices (E) and the external surface of the wall (1.1, 2.1); that is, between the surfaces in which heat exchange occurs, resulting in a drop in heat transfer.

Considering Figure 2, the top view allows observing the base (1) as well as the elements in contact with the base (1), with the exception of the fin block (3) which has been eliminated only to facilitate visual access and allow better describing an example of the invention.

In the top view, the perimeter of the cover (2) is shown with a continuous line, leaving therein the inlet port (I) and the outlet port (O) so that the liquid coolant enters and exits by means of the fluid communication between said ports (I, O) and the chamber (C) defined between the cover (2) and the base (1).

This same figure in top view shows the area occupied by the electronic devices (E), particularly the area which is in contact with the wall (1.1) of the base (1). This set of areas is shown in the form of black rectangles.

In the wall (1.1) of the base (1) there are exchange regions (R), wherein the wall (1.1) is formed by a metallic heat transfer material and a wall that is thinner than in the configurations of the state of the art, given that the resistance requirements thereof do not necessarily include absorbing bending stresses, only the pressure exerted by the electronic devices (E) pressed against the outer surface thereof.

The area representing the heat exchange regions (R) which are made of a metallic heat transfer material is shown in grey. In this embodiment, copper has been chosen as the highly heat conducting material, however it could be any other of the metallic heat transfer materials described above (preferably materials comprising copper or aluminum as the metal in the highest amount by weight).

Another rectangle is shown externally to the heat exchange regions (R), this time shown with double oblique stripes, depicting a part of the base (1) formed in steel as a structural metallic material and identified with the letters St, however, it could be any other of the structural metallic materials described above (preferably, steel materials and materials comprising aluminum as the metal in the highest amount by weight).

The configuration according to this embodiment is a frame configuration around the heat exchange regions (R) with transverse segments forming islands in which plates made of the metallic heat transfer material are inserted. The internal regions (R) according to this embodiment are completely surrounded by steel St, although in this embodiment the end regions do not have steel at both longitudinal ends.

The steel frame verifies that the distance (d) extends longitudinally with d=d₂ which is the distance between the farthest points of the heat exchange regions (R), leaving all of them between the area with steel St reinforcement. That is, the steel part extends longitudinally a segment such that all the heat exchange regions (R) are inside the segment. It is said to be according to the longitudinal direction because solo only a projection according to the longitudinal direction is considered regardless of the position and the dimensions thereof according to other directions (transverse and heightwise).

However, in an example in which the stress requirements are not so high it would be enough that at least one exchange region (R) has the longitudinal steel St reinforcement, i.e. the distance (d) would verify that d=d₁ as also shown in Figure 2. In this case, the area with double oblique stripes would also be reduced to the longitudinal extension of the exchange region (R) according to the longitudinal direction. This same configuration with individual reinforcements for a heat exchange region (R), according to another example, is repeated for each and every heat exchange region (R).

This steel St frame or reinforcement is the one that mainly absorbs the bending moments produced by the forces distributed according to the longitudinal direction X-X'.

According to another embodiment, the steel St frame which houses parts made of a metallic heat transfer material completely surrounds each of these parts which in turn form the heat exchange regions (R).

The distribution on both sides of the fixing means (4) also generates transverse bending moments which, although of lesser importance because their width is smaller than the length of the base (1), can also give rise to undesired deformations. These transverse bending stresses are absorbed by the steel cross members configured inside the steel frame or reinforcement.

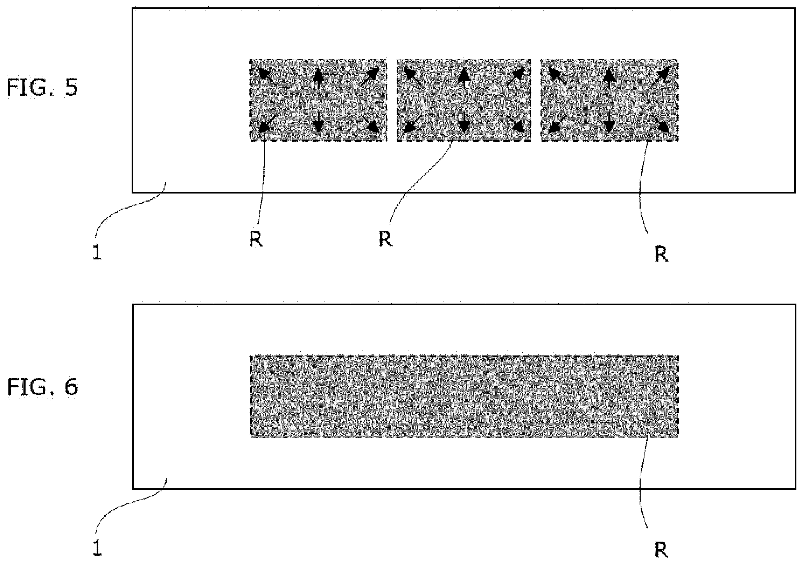

A specific way of carrying out this embodiment consists of extending the steel frame to the rest of the base, i.e. causing the perimeter region with double oblique stripes to coincide with the perimeter of the base (1) such that the entire base is made of steel except for the plates made of heat transfer metallic material located in the heat exchange regions (R). This situation will be described in the examples using Figures 5 and 6. The material of the base (1) which is not the steel St part and also not the heat exchange region can be of a third material and particularly either of the two mentioned, i.e., steel or the material of the exchange region.

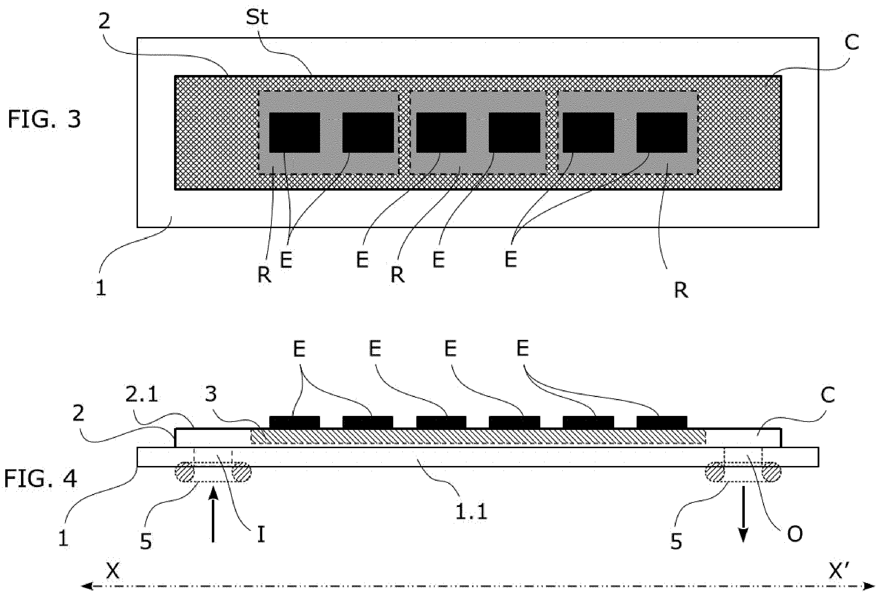

According to another embodiment shown in Figure 3, the cover (2) is the steel (St) part, although it could be any other of the structural metallic materials described above, so that it extends even beyond the inlet port (I) and the outlet port (O) according to the longitudinal direction (X-X') giving rise to the necessary bending stiffness. In this embodiment, the base (1) can be made of a highly heat conducting material or also of steel.

According to this same example shown in Figure 3, the cover has a plurality of heat exchange regions (R) configured in another material or with a smaller thickness, for example, to favor heat exchange with the electrical or electronic devices (E). However, in the case of the cover (2) which, in this embodiment, is configured in a stamped sheet metal, the thickness thereof is thinner and allows suitable heat transmission without reducing its thickness even though it is made of steel.

This Figure 3 shows by way of example a heat exchanger without perforations for the fixing means given that the action of attachment and force against the electrical or electronic devices (E) is achieved with an external anchoring configured to press the base (1), the cover (2), or both (1, 2).

Figure 4 is a front view schematically depicting the same embodiment which clearly shows the electrical or electronic devices (E) located on the outer surface of the cover (2), such that the heat exchange regions (R) exist on the wall (2.1) of the cover (2).

In this example, by comparing it with that shown in Figure 1, it can be seen that the fin block (3) in both cases is attached to the surface of the wall (1.1, 2.1) through which heat conduction which evacuates heat from the electrical or electronic devices occurs and is not attached to the other wall. Particularly, in Figure 1 the fin block (3) is attached to the wall (1.1) of the base (1) and not to the cover (2) and in Figure 4 the fin block (3) is attached to the wall (2.1) of the cover (2) but not to the base (1).

Figure 5 shows an embodiment of a base (1) without showing the inlet port (I) or the outlet port (O), wherein the wall (1.1) of the base (1) is formed entirely by a steel (St) plate acting as the main resistant element of the heat exchanger, although it could be any other of the structural metallic materials described above. This steel wall (1.1) comprises rectangular windows occupied by parts made of a metallic heat transfer material, giving rise to the heat exchange regions (R). In this embodiment, this metallic heat transfer material is aluminum or copper.

Figure 6 schematically shows another embodiment in which the wall (1.1) of the base (1) is now made of steel, although it could be any other of the structural metallic materials described above, and includes a single window in which there is a part made of a metallic heat transfer material, giving rise to a heat exchange region (R) adapted to receive one or a plurality of electronic devices (E) to be cooled.

If the application for which the heat exchanger is designed has more demanding specifications for use: significant temperature changes, high pressures or stresses which may cause bending, then a more specific example such as the one shown in Figure 5 or Figure 6 uses of a metallic sheet which is located covering at least all the attachments between different metallic materials, preferably the entire area of the base (1). This sheet ensures the leaktightness in such attachments after welding.

According to one embodiment, the sheet melts during passage through the furnace intended to cause the brazing of the rest of the parts. In this embodiment, the sheet does not only ensure leaktightness with the part or parts made of a metallic heat transfer material in the i heat exchange region (R), but rather also melts during passage through the furnace and allows attachment with the fin block or blocks (3).

According to another embodiment, between the sheet and the substrate formed by the wall (1.1) that is made of steel, although it could be any other of the structural metallic materials described above, and the parts made of a metallic heat transfer material, there is placed a brazing paste which greatly secures the attachment without the metallic sheet necessarily melting.

Determining whether or not the sheet melts is by means of selecting a metal with a melting point below or above, respectively, the established temperature of the welding furnace.

The sheet is preferably very thin so that it does not increase thermal resistance in the heat exchange region (R).

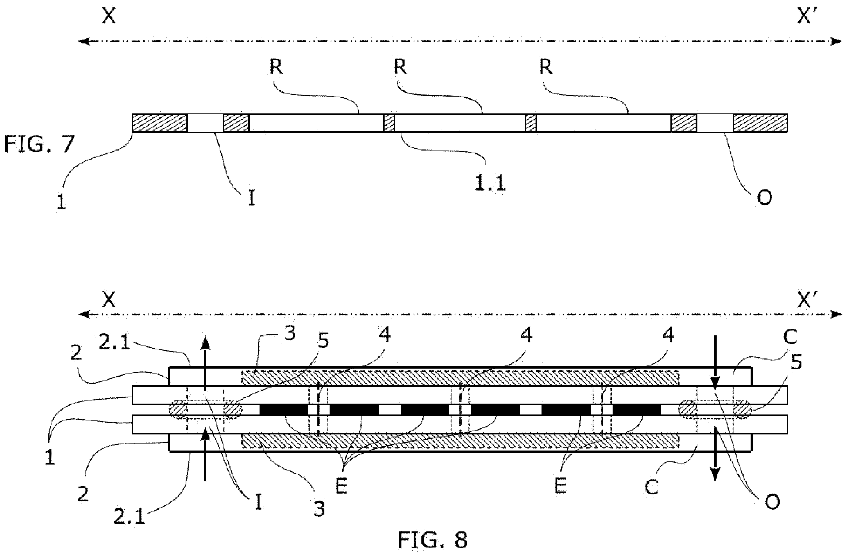

Figure 7 shows the section of Figure 5 in which the structure resulting from inserting parts made of a different material, a metallic heat transfer material, into the base (1), giving rise to the heat exchange regions (R), can be seen.

Figure 8 shows a sandwich-like configuration in which two heat exchangers configured according to any of the described embodiments are located with the outer areas configured to be in contact with the electronic devices (E) and to face one another, particularly with both being in contact with the electronic devices (E) that are retained configuring a sandwich.

In all the cases described as detailed examples and based on the figures, the fin block (3) is spaced apart from the cover (2) given that the steel part provides sufficient bending stiffness to the heat exchanger. This allows using a single weld between the fin block (3) and the internal surface of the wall (1.1) of the base (1) without attachment with the internal surface of the cover being necessary. Internal surfaces are understood to mean those which give rise to the inside of the chamber (C).

The example of Figure 8 show coinciding inlets and outlets of the exchanger located above and below because they are depicted in a front view, although in a top view they are offset, preventing mechanical interference; for example, the heat exchanger located at the upper part according to the orientation of the figure has the inlet for the liquid coolant on the right and the outlet on the left and, the heat exchanger located at the lower part also according to the orientation of the figure has the inlet for the liquid coolant on the left and the outlet on the right.

## Claims

1. A heat exchanger for cooling one or more electrical or electronic devices (E), comprising:
- a base (1) comprising
an inlet port (I) for the entry of a coolant,
an outlet port (O) for the exit of the coolant,
a wall (1.1) extending along a longitudinal direction (X-X'), the direction which connects the inlet port (I) and the outlet port (O) of the base (1),
- a cover (2) attached on the base (1) and configured to establish a chamber (C) for the passage of the coolant between the inlet port (I) and the outlet port (O) of the base (1) and wherein the cover (2) comprises a wall (2.1) extending along the longitudinal direction (X-X');
wherein the wall (1.1) of the base (1) or the wall (2.1) of the cover (2) or both (1.1, 2.1) comprise at least one heat exchange region (R) adapted to transfer heat from an outer area to an inner area of the chamber (C) and opposite the outer area;
**characterized in that**
- the wall (1.1) of the base (1) or the wall (2.1) of the cover (2) or both (1.1, 2.1) comprises a structural metallic material which is selected from:
∘ steel;
and
∘ a metallic material comprising aluminum as the ingredient in the highest amount by weight; and,
- the wall (1.1) of the base (1) or the wall (2.1) of the cover (2) or both (1.1, 2.1) comprising a structural metallic material extend at least one segment along the longitudinal direction (X-X') wherein, at least one heat exchange region (R) is arranged between the ends of said segment also according to the longitudinal direction (X-X'); and
at least one heat exchange region (R) comprises, and particularly consists of, a metallic heat transfer material.

2. The heat exchanger according to the preceding claim, wherein the metallic heat transfer material in the at least one heat exchange region (R) is selected from:
∘ steel, preferably carbon steel;
∘ a metallic material comprising copper as the ingredient in the highest amount by weight; and
∘ a metallic material comprising aluminum as the ingredient in the highest amount by weight.

3. The heat exchanger according to any of the preceding claims, wherein the structural metallic material and the metallic heat transfer material are different.

4. The heat exchanger according to any of claims 1 or 2, wherein the structural metallic material and the metallic heat transfer material are the same material.

5. The heat exchanger according to any of the preceding claims, wherein the at least one segment of the structural metallic material is such that a plurality of heat exchange regions (R) are arranged between the ends of said segment according to the longitudinal direction (X-X').

6. The heat exchanger according to any of the preceding claims, wherein the wall (1.1, 2.1) of the base (1), of the cover (2), or of both (1, 2), is a flat plate.

7. The heat exchanger according to any of the preceding claims, wherein the at least one heat exchange region (R) is a continuous region in the metallic heat transfer material comprised in said region, said region being adapted to receive one or more electronic devices.

8. The heat exchanger according to any of the preceding claims, comprising an attachment material between the metallic heat transfer material comprised in the at least one heat exchange region (R) and the structural metallic material.

9. The heat exchanger according to claim 8. wherein the attachment between the metallic heat transfer material comprised in the at least one heat exchange region (R) and the structural metallic material is obtained by leak-tight sealing through the attachment material.

10. The heat exchanger according to any of the preceding claims, wherein the cover (2) is made of a sheet metal and comprises a larger flat surface limited along the perimeter by a perimeter wall, wherein the perimeter wall of the cover (2) is fixed to the base (1).

11. The heat exchanger according to any of the preceding claims, comprising one or more fin blocks (3) for heat exchange (R) arranged inside the chamber (C) for the passage of the coolant, wherein the at least one fin block (3) for heat exchange (R) is attached to the inner area of the wall (1.1, 2.1) of a heat exchange region (R) and is separated from the internal surface of the chamber (C) located opposite, that is, if the fin block (3) is attached to the wall (1.1) of the base (1) then it is separated from the cover (2) and, if the fin block (3) is attached to the wall of the cover (2.1) then it is separated from the base (1).

12. The heat exchanger according to claim 11, wherein the fins comprise
∘ a metallic material comprising copper as the ingredient in the highest amount by weight; or
∘ a metallic material comprising aluminum as the ingredient in the highest amount by weight.

13. The heat exchanger according to any of the preceding claims, wherein the segment of the structural metallic material is a side wall of the cover (2).

14. The heat exchanger according to any of the preceding claims, wherein it further comprises fixing means (4) configured to exert a force transverse to the wall (1.1) of the base (1).

15. A heat exchanger module, comprising at least two adjacent heat exchangers according to any of claims 11 to 14, wherein:
- the two or more heat exchangers are adapted to receive one or more electrical or electronic devices (E) to be cooled interposed between two adjacent heat exchangers and in thermal contact with the heat exchange regions (R) of both heat exchangers,
- it comprises fixing means (4) pressing the one or more electrical or electronic devices (E) to be cooled together, and
- the fixing means (E) press the compressible sealing gaskets (5) together.
